Europäisches Patentamt

European Patent Office

Office européen des brevets

(19)

(11) Numéro de publication : **0 023 171**
**B1**

# FASCICULE DE BREVET EUROPÉEN

(12)

(45) Date de publication du fascicule du brevet :
16.11.83

(51) Int. Cl.³ : **H 03 H 9/08, H 03 H 9/10**

(21) Numéro de dépôt : **80401008.0**

(22) Date de dépôt : **03.07.80**

(54) **Oscillateur haute fréquence autothermostaté.**

(30) Priorité : **18.07.79 FR 7918553**

(43) Date de publication de la demande :
**28.01.81 Bulletin 81/04**

(45) Mention de la délivrance du brevet :
**16.11.83 Bulletin 83/46**

(84) Etats contractants désignés :
**CH DE GB LI NL SE**

(56) Documents cités
**FR A 1 267 965**
**FR A 2 338 607**
**FR A 2 353 997**
**FR A 2 394 178**
**GB A 406 572**
**US A 2 115 145**
**US A 2 969 471**
**US A 3 007 023**
**US A 3 121 153**
**US A 3 299 300**
**US A 3 431 392**
**US A 4 157 466**

**ELECTRONICS AUSTRALIA, vol. 37, no. 7, octobre 1975 SYDNEY (AU) P. MATHIESON : « Economical crystal oven » page 77**

(73) Titulaire : **ETAT-FRANCAIS représenté par le DELEGUE GENERAL POUR L'ARMEMENT**
**Bureau des Brevets et Inventions de la Délégation Générale pour l'Armement 14, rue Saint-Dominique F-75997 Paris Armées (FR)**

(72) Inventeur : **Besson, Raymond Jean-Claude**
**23, rue Octave David**
**F-25000 Besançon (FR)**
Inventeur : **Valentin, Jean-Pascal**
**F-25115 Pouilley les Vignes (FR)**

## Oscillateur haute fréquence autothermostaté

La présente invention a pour objet un oscillateur haute fréquence autothermostaté, du type comprenant, monté dans une enceinte étanche, un résonateur piézoélectrique constitué par au moins un cristal piézoélectrique muni d'une partie périphérique continue formant bague reliée à une partie centrale par une zone intermédiaire qui est évidée dans sa majeure partie et comprend au moins deux ponts de liaison pour rendre solidaires l'une de l'autre la partie centrale et la partie périphérique, et deux plateaux diélectriques pour supporter et maintenir des électrodes excitatrices sans contact avec et en regard respectivement de chacune des faces de l'une des parties centrale et périphérique qui constitue alors la partie active vibrante du cristal, l'autre partie du cristal qui constitue une partie de support pour le cristal étant maintenue en position entre les plateaux diélectriques directement et sans éléments intermédiaires. Un tel oscillateur est décrit dans le document FR-A-2 353 997.

Dans les oscillateurs utilisant des résonateurs piézoélectriques à cristal de quartz, on tend à alimenter les électrodes d'excitation du cristal avec des puissances très faibles, comprises entre environ 0,1 µW et une vingtaine de microwatts et généralement voisines de 5 µW, afin de limiter les dérives, sauts de fréquence, voire même les risques d'explosion du cristal. Parallèlement, le résonateur est placé dans un thermostat de très haute précision afin de limiter au maximum les fluctuations de la température du cristal, qui ont toujours une répercussion sur la fréquence d'oscillation.

La présente invention a notamment pour objet de fournir un oscillateur de haute précision qui augmente l'insensibilité du résonateur aux fluctuations de la température externe tout en limitant fortement les dépenses globales d'énergie nécessaires au fonctionnement de l'oscillateur, et notamment l'énergie dépensée dans le thermostat dans lequel est placé l'oscillateur.

Ces buts sont atteints grâce à un oscillateur du type mentionné au début, dans lequel, conformément à l'invention, le contact, thermiquement isolant, entre la partie de support du cristal et les deux plateaux diélectriques est limité à une surface discontinue d'étendue réduite constituée par un nombre fini d'éléments de surface de contact directe, au moins un écran réflecteur électromagnétique de radiations infra-rouges est disposé à l'intérieur même de l'enceinte étanche au voisinage immédiat du résonateur piézoélectrique et la puissance électrique appliquée aux électrodes excitatrices est d'au moins environ cinquante microwatts.

Le nombre fini d'éléments de surface de contact de la partie de support du cristal peut être par exemple égale à quatre.

Dans des oscillateurs à cristal piézoélectrique, comme celui montré dans le brevet US 2 969 471, on sait chauffer, par apport extérieur, le cristal dans un espace entouré d'un écran réflecteur.

Mais dans l'oscillateur selon l'invention, le niveau de la puissance électrique appliquée aux électrodes excitatrices permet de réaliser un chauffage interne dans la masse même de la partie active de résonateur grâce à la puissance consommée dans la résistance motionnelle du cristal. Du fait de l'isolation de la partie active du cristal par rapport aux plateaux support, grâce à l'existence d'un nombre limité de ponts de liaison de faible épaisseur entre la partie active du cristal et sa partie formant support, et d'un nombre également limité d'éléments de surface de contact entre la partie de support du cristal les plateaux diélectriques, et grâce à la présence d'au moins un écran électromagnétique réflecteur de radiations infra-rouges au voisinage immédiat du résonateur, les pertes de chaleur par rayonnement et conduction sont limitées et le cristal piézoélectrique peut être maintenu à sa température d'inversion essentiellement grâce à la chaleur dissipée dans la partie active du cristal par la vibration qui produit un chauffage interne dans la masse du cristal de référence. Par suite, l'oscillateur peut être installé dans un thermostat de très faible précision et consommant peu d'énergie. Globalement, la présente invention permet d'économiser une énergie appréciable puisqu'une puissance électrique par exemple de l'ordre d'un milliwatt suffit à maintenir le cristal à sa température d'inversion, alors que les méthodes classiques consistant à maintenir le cristal en température grâce à l'ambiance externe régulée par un thermostat de grande précision nécessite une puissance de plusieurs watts. Surtout, le chauffage du cristal par une vibration interne permet de produire un flux de chaleur dirigé vers l'extérieur du cristal et conservant toujours le même sens. Cette propriété, ajoutée au fait que le cristal est chauffé dans sa masse et non pas seulement par sa surface, accroît la stabilité de la température du cristal et son insensibilité aux fluctuations externes, par exemple aux variations diurnes. Les dérives de fréquence sont ainsi extrêmement réduites, malgré le haut niveau de l'énergie électrique appliquée aux électrodes. Par exemple, on peut obtenir une dérive de 3, 3 $10^{-10}$ Hz/jour pour un résonateur à quartz de 5 MHz, P5, coupe AT fonctionnant avec une puissance de 1600 microwatts.

Selon des caractéristiques particulières de la présente invention, les parties des faces internes des plateaux diélectriques situées en regard du cristal mais non recouvertes d'électrodes et non en contact avec le cristal sont polies et recouvertes d'un écran électromagnétique réflecteur de radiations infra-rouges.

Les faces externes des plateaux diélectriques sont polies et recouvertes d'un tel écran.

La partie de support du cristal est polie et recouverte d'un tel écran.

Les écrans électromagnétiques réflecteurs de radiations infra-rouges peuvent être constitués par un dépôt d'un métal tel que de l'or, de l'argent, du cuivre ou être constitués par des éléments réflecteurs multicouches correspondant à un quart de longueur d'onde pour les radiations infra-rouges.

La présence d'un écran électromagnétique déposé sur les plateaux diélectriques eux-mêmes et/ou sur la partie support du cristal accroît sensiblement l'efficacité du chauffage interne réalisé dans la partie active du cristal, et réalise un véritable confinement de l'énergie infra-rouge, car l'émission d'énergie par le résonateur est limitée au maximum.

L'oscillateur autothermostaté selon l'invention comprend un capteur de température disposé à proximité immédiate de la paroi de l'enceinte étanche entourant le résonateur piézoélectrique et des moyens sont prévus pour réguler le niveau de la puissance électrique fournie aux électrodes déposées sur les plateaux diélectriques en fonction des signaux délivrés par le capteur.

Selon un mode particulier de réalisation, les électrodes excitatrices produisant un champ électrique dans la partie active du cristal piézoélectrique reçoivent d'une part une puissance électrique pour exciter le cristal selon un mode utile choisi pour déterminer une référence de fréquence et d'autre part une puissance électrique supérieure ou égale à 50 microwatts pour exciter le cristal selon un mode, ou un partiel, ou une vibration anharmonique différents du mode utile choisi pour déterminer une référence de fréquence.

Cette caractéristique est particulièrement avantageuse, car la puissance électrique d'excitation du cristal en vue de réaliser une référence de fréquence peut être ajustée à une valeur pour laquelle le vieillissement est pratiquement nul, tandis que la vibration du cristal sur un mode différent, non utilisé comme référence de fréquence, permet, dans la mesure où le couplage avec la vibration de base est suffisamment faible, de produire un chauffage interne supplémentaire de la partie active du cristal.

Il est ainsi possible de choisir comme vibration de base un mode pour lequel le coefficient de qualité du cristal est excellent et comme vibration annexe de chauffage un autre mode pour lequel le coefficient de qualité du cristal est moins élevé. En ajustant la puissance d'excitation de la vibration de base, qui présente déjà un très fort coefficient de qualité, à une valeur optimum pour laquelle le vieillissement est quasi nul, les performances de stabilité dans le temps pourront être excellentes. La vibration annexe permet dans ce cas de compléter le chauffage interne du cristal pour atteindre facilement la température d'inversion et peut être effectuée de façon d'autant plus avantageuse que le coefficient de qualité pour cette vibration annexe est plus faible.

Lors de la mise en œuvre de plusieurs modes de vibration différents, plusieurs systèmes d'électrodes différents peuvent être utilisés, mais dans le cas où l'on réalise une sélection électroniquement par filtrage, une seule paire d'électrodes est suffisante.

Des écrans électromagnétiques réflecteurs de radiations infra-rouges multiples intérieurs ou extérieurs à l'enceinte étanche peuvent être utilisés pour accroître le confinement de l'énergie électromagnétique dans le cristal.

Dans certains cas, des moyens classiques de chauffage d'appoint peuvent également être adjoints au dispositif selon l'invention afin de bénéficier d'un temps de mise en température réduit et simultanément d'un maintien en température du cristal avec une énergie extrêmement réduite.

D'autres caractéristiques et avantages de la présente invention apparaîtront mieux à la lecture de la description qui fait suite de modes particuliers de réalisation de l'invention, en référence aux dessins annexés sur lesquels :

La figure 1 est une vue schématique en coupe d'un mode particulier de réalisation de l'invention,

la figure 2 est une vue schématique en coupe d'un autre mode de réalisation de l'invention,

la figure 3 est une vue en perspective d'un plateau support d'électrode conforme à l'invention,

la figure 4 est une vue agrandie en coupe axiale de la partie des dispositifs des figures 1 et 2 qui constitue un résonateur,

la figure 5 est une vue en coupe, selon la ligne V-V de la figure 6 d'une variante de réalisation,

la figure 6 est une vue de dessus d'un exemple de cristal piézoélectrique utilisable dans le cadre de l'invention.

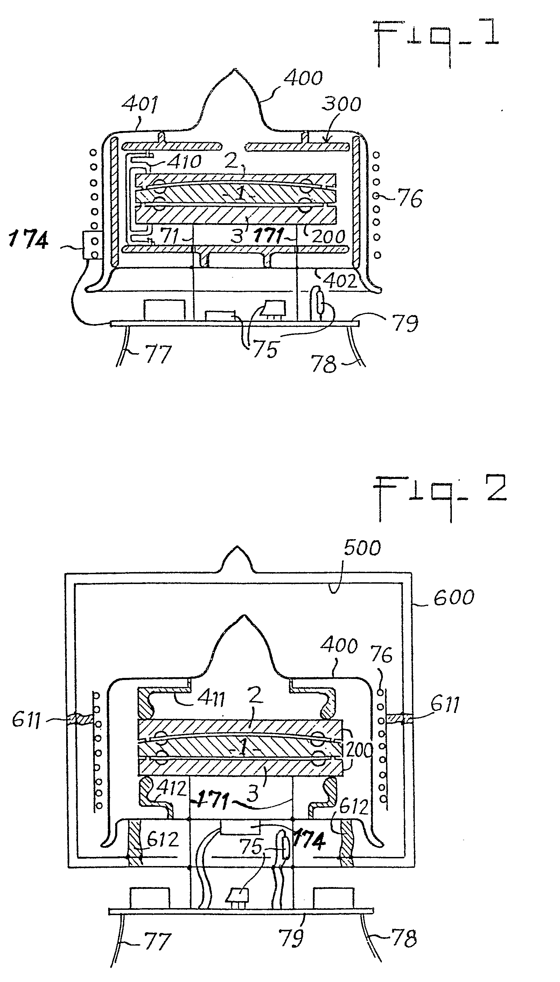

La figure 1 représente schématiquement un oscillateur comprenant d'une part des circuits électroniques 75 montés sur un support 79, et d'autre part un ensemble formant résonateur qui est disposé à l'intérieur d'une enceinte étanche 400. L'enceinte étanche 400 peut comprendre par exemple un capot métallique 401 poli et doré sur ses deux faces afin de posséder un bon pouvoir réfléchissant, et un socle 402 qui peut être également métallique mais, dans l'exemple de la figure 1, est constitué de préférence par une plaque isolante en alumine.

A l'intérieur même de l'enceinte 400, est disposé un écran électromagnétique 300 adapté pour réfléchir principalement l'infra-rouge. L'écran 300 comprend de préférence des plaques isolantes en une matière peu conductrice de la chaleur, sur lesquelles on a réalisé un dépôt réflecteur. L'écran 300 peut comprendre plusieurs plaques montées sur le capot 401 ou l'embase 402 de l'enceinte 400.

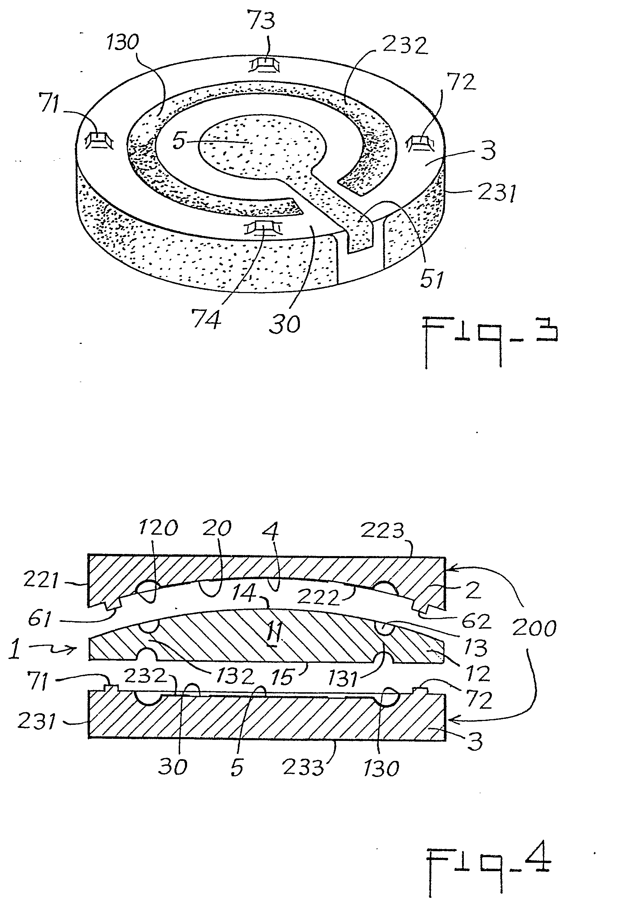

Le résonateur proprement dit comprend essentiellement un cristal piézoélectrique 1 et deux plateaux diélectriques 2, 3 destinés à supporter des électrodes excitatrices devant être placées à très faible distance du cristal 1, mais sans contact avec celui-ci. Le résonateur 1, 2, 3, qui apparaît de façon plus détaillée sur la figure 4, est monté à l'intérieur de l'enceinte 400 et de l'écran 300 à l'aide de pinces 410 adaptées pour maintenir en position l'ensemble 1, 2, 3 tout en limitant les transferts de chaleur par conduction.

Un écran électromagnétique 200, qui sera décrit plus en détail en référence aux figures 3 et 4, est disposé à proximité immédiate du résonateur 1, 2, 3 et, de préférence, fait corps avec le résonateur. La structure de base du résonateur piézoélectrique 1, 2, 3 est du type à électrodes non adhérentes, tel que décrit notamment dans la demande de brevet français 2 338 607. Ainsi, un cristal piézoélectrique 1, par exemple un cristal de quartz, comprend une partie centrale 11 reliée à une partie périphérique 12 par un nombre limité de ponts de liaison 131, 132, 133, 134 (figures 4 à 6) dont l'épaisseur est de préférence réduite par rapport à l'épaisseur à la fois de la partie centrale 11 et de la partie périphérique 12. Dans le cadre de la présente application, il est particulièrement important que les ponts de liaison 131 à 134 soient d'épaisseur et/ou de largeur très limitées afin de réduire au maximum les transferts de chaleur par conduction entre la partie active du cristal et la partie formant support. Un nombre de ponts de liaison égal à quatre constitue un optimum tandis qu'un pont unique constitué par une zone intermédiaire 13 amincie entre les parties centrale 11 et périphérique 12, mais ne présentant aucune partie évidée, est à exclure du cadre de la présente invention.

Dans le mode de réalisation des figures 3 à 6, des électrodes 4 et 5 sont déposées sur les faces internes 20, 30 des plateaux diélectriques 2 et 3 respectivement, en regard des faces 14 et 15 du cristal 1, au niveau de la partie centrale 11 qui est ainsi la partie active vibrante. Selon une caractéristique particulière de l'invention, la partie 12 du cristal 1 qui constitue la partie de support du cristal, n'est en contact avec les plateaux 2, 3 que par une surface discontinue d'étendue réduite constituée par un nombre fini d'éléments de surface de contact tels que 61, 62 ou 71, 72, 73, 74. Les surfaces de contact telles que 71 à 74 (figure 3) peuvent être facilement réalisées par exemple par attaque chimique de la surface 30 du plateau 3, si les points de contact 71 à 74 ont été au préalable protégés de l'action d'attaque par dépôt sur la surface 30 de résines protectrices par exemple. Il est avantageux que les éléments de surface de contact tels que 61, 62, 71 à 74 soient régulièrement répartis par rapport à la partie périphérique 12 avec laquelle elles coopèrent et soient en nombre limité, par exemple trois éléments ou de préférence quatre éléments 71 à 74 par plateau support, disposés en croix.

Selon une caractéristique de la présente invention, un écran réflecteur 200 est déposé sur le résonateur 1, 2, 3 lui-même. L'écran 200 peut être constitué par un dépôt métallique tel que de l'or, de l'argent ou du cuivre, par exemple. Toutefois, des dépôts multicouches non métalliques correspondant à un quart de longueur d'onde pour les radiations infra-rouge peuvent être également utilisés comme écrans réflecteurs. Dans tous les cas, les dépôts métalliques ou multicouches sont réalisés sur des surfaces précédemment polies. On voit sur les figures 3 et 4 que l'écran 200 est constitué par un ensemble de dépôt réalisés sur les diverses faces des plateaux 2 et 3. Des dépôts 222, 232 sont réalisés sur les faces internes 20, 30 des plateaux 2, 3 dans les zones qui sont démunies d'électrodes et ne sont pas porteuses, c'est-à-dire notamment entre les éléments de surface de contact tels que 61, 71 et les électrodes 4, 5. Les couches 222, 232 qui se trouvent au voisinage immédiat de la partie centrale active vibrante 11 du cristal 1 jouent un rôle prépondérant dans la concentration de la chaleur émise par la partie 11 du cristal 1.

Les couches réflectrices externes 221, 223 et 231, 233 réalisées sur les faces externes des plateaux 2 et 3, par l'enceinte qu'elles forment autour du résonateur, contribuent également de façon essentielle au confinement dans le résonateur de l'énergie thermique développée dans la partie vibrante du cristal 1. En effet, les plateaux 2, 3 équipés de leurs couches réflectrices 221, 223, 231, 233 ne peuvent émettre vers l'extérieur qu'une quantité extrêmement limitée de rayonnement et contribuent ainsi à empêcher une évacuation de la chaleur apparaissant dans le cristal 1.

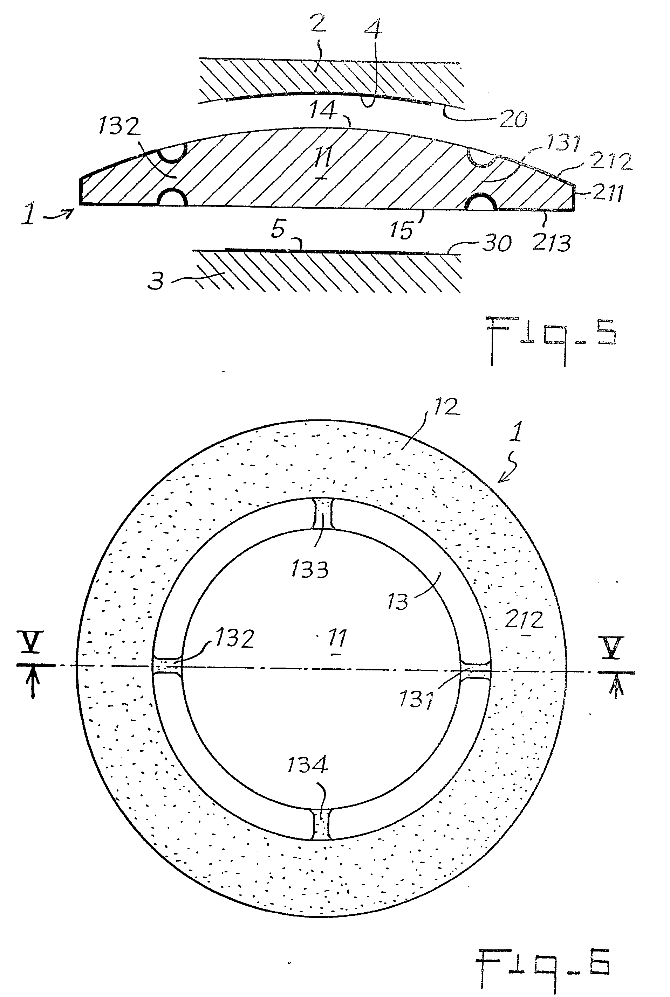

La variante de réalisation représentée sur les figures 5 et 6 montre qu'un dépôt réflecteur 211, 212, 213 faisant partie de l'écran 200 peut être réalisé sur le cristal lui-même, sur les parties inactives distantes de la partie centrale active vibrante. Ainsi, la tranche du cristal 1 peut être recouverte, après polissage, d'une couche 211 analogue aux couches 221 ou 231 par exemple. Les faces 14 et 15 du cristal peuvent également être recouvertes de couches 212, 213 formant écran réflecteur, dans la partie 12, et éventuellement la partie intermédiaire de liaison 13 munie de ponts 131, 132, 133, 134. Le rayonnement du cristal 1 lui-même est alors extrêmement limité, sans que les qualités du cristal soient affectées, puisque la partie active vibrante 11 reste exempte de tout dépôt d'électrode ou de couche réflectrice.

Le fonctionnement de l'oscillateur selon l'invention sera maintenant expliqué de façon détaillée.

Comme on le sait, le cristal piézoélectrique d'un résonateur destiné à servir de référence de fréquence doit être porté à sa température d'inversion et maintenu rigoureusement à cette température, qui est supérieure à la température ambiante, pour que le système présente une stabilité dans le temps qui soit la meilleure possible. Cette mise en température et surtout le maintien à cette température sont réalisés selon l'invention essentiellement par chauffage interne de la partie active du cristal du résonateur par la puissance consommée dans la résistance motionnelle du cristal.

Ceci est possible grâce au fait que d'une part le niveau de puissance appliqué aux électrodes excitatrices du résonateur est particulièrement élevé, c'est-à-dire supérieur à au moins environ cinquante microwatts et pouvant être de l'ordre de quelques milliwatts et d'autre part le résonateur est lui-même isolé de l'extérieur par au moins un ou plusieurs écrans électromagnétiques.

Le réglage de la température du cristal à l'inversion est ainsi effectué en ajustant le niveau de la puissance électrique appliquée au résonateur. Cet ajustement peut être effectué automatiquement en ajustant le niveau de puissance électrique en fonction d'une température extérieure d'un point de référence situé au voisinage du résonateur, mais pouvant être extérieur à l'enceinte 400. Ainsi, le point de référence peut être par exemple situé sur l'enceinte 400 et un capteur 174 situé en ce point permet d'asservir le niveau d'alimentation des électrodes du résonateur en fonction des fluctuations externes de température et ainsi de maintenir pour le cristal lui-même une température constante. Le fait que le cristal soit ainsi chauffé dans sa masse et devienne thermiquement actif puisqu'il est porté à une température supérieure à la température externe favorise la stabilité du fonctionnement puisque le gradient de température est toujours dans le même sens, contrairement au cas où le chauffage du cristal se fait par apport externe de chaleur. Le maintien en température du cristal reste ainsi beaucoup plus indépendant des variations extérieures de température et il est possible d'utiliser un thermostat d'appoint de qualité relativement médiocre.

Par ailleurs, il a été constaté que le vieillissement d'un résonateur est fonction de la puissance de fonctionnement de celui-ci et devient nul pour une certaine valeur de puissance qui est fonction du type de cristal utilisé. Il est ainsi particulièrement intéressant de prévoir une alimentation du résonateur avec une puissance qui, pour la vibration utile utilisée, est ajustée à une valeur voisine de la puissance pour laquelle le vieillissement est nul. Dans le cas où cette puissance reste insuffisante pour chauffer complètement la masse de la partie active du cristal et conduire à la température d'inversion, il est alors possible d'utiliser une autre vibration du cristal, non utilisée comme référence de fréquence, pour participer à la mise en température du cristal. Cette autre vibration peut être une vibration anharmonique, une vibration sur un partiel différent ou encore sur un mode différent. Cette vibration supplémentaire servant exclusivement au chauffage peut être appliquée avec une puissance comprise entre environ 50 microwatts et un milliwatt, bien que cette dernière valeur puisse être largement dépassée.

Selon un premier mode de réalisation, la vibration supplémentaire de chauffage est appliquée au moyen d'une paire d'électrodes additionnelles superposées aux électrodes principales 4 et 5, en étant isolées de celles-ci, ou encore disposées latéralement par rapport aux électrodes 4 et 5 sur les plateaux 2 et 3 mais toujours au voisinage de la partie centrale active 11 du cristal.

Selon un autre mode de réalisation, une seule paire d'électrodes 4, 5 est déposée sur les plateaux diélectriques 2, 3 en regard de la partie active 11 du cristal pour exciter cette partie active sur un mode utile de référence de fréquence et sur un mode additionnel de chauffage, et les circuits électroniques 75 de l'oscillateur comprennent des circuits de filtrage pour isoler la composante utile de référence de fréquence du signal électrique appliqué aux électrodes. Dans ce cas, la configuration du résonateur reste ainsi particulièrement simple.

On donnera ci-dessous divers exemples de modes de vibration utilisables et de puissances optimum à mettre en jeu, en fonction de divers types de cristaux.

Avec un cristal de quartz de coupe AT, dimensionné et excité pour vibrer à 5 MHz sur le mode partiel 5, la puissance électrique fournie aux électrodes pour exciter la partie active du cristal sur ce mode partiel 5 en vue d'obtenir un vieillissement le plus faible possible, doit être comprise entre environ 70 et 110 microwatts.

Avec un cristal de quartz de coupe SC, dimensionné et excité pour vibrer à 5 MHz sur le mode C et le mode partiel 3, la puissance électrique fournie aux électrodes pour exciter la partie active du cristal sur ce mode C et le mode partiel 3 en vue d'obtenir un vieillissement le plus faible possible, doit être compris entre environ 140 et 180 microwatts.

Avec un tel type de quartz de même que plus généralement avec les cristaux de quartz à double rotation il est possible d'utiliser en outre une vibration additionnelle de chauffage en excitant le cristal pour le faire vibrer sur le mode B. Dans la mesure où la vibration additionnelle n'est pas prise en compte comme référence de fréquence, le vieillissement n'intervient pas et la puissance électrique fournie aux électrodes pour exciter la partie active du cristal sur le mode B peut être sans inconvénient de l'ordre de quelques centaines ou milliers de microwatts et peut par exemple être voisine de 1 500 microwatts.

D'une manière générale, pour un cristal présentant un bon coefficient de qualité sur un premier mode partiel et un coefficient de qualité inférieur sur un autre mode partiel, on aura intérêt à utiliser d'une part le premier mode partiel pour obtenir une référence de fréquence et simultanément contribuer au moins en partie au chauffage du cristal, et dans la mesure où il n'existe pas de couplage excessif entre les deux modes de vibration, à utiliser d'autre part le deuxième mode partiel pour assurer un chauffage additionnel du cristal, qui sera d'autant plus efficace que pour ce deuxième mode partiel la résistance motionnelle est en général plus élevée.

Dans tous les cas, un oscillateur conforme à l'invention présentera une stabilité d'autant meilleure que la différence de température entre le cristal lui-même et l'environnement externe sera plus élevée. L'oscillateur, muni de son chauffage interne par les vibrations appliquées au cristal sera ainsi avantageusement placé dans une ambiance à faible température, par exemple dans de l'azote liquide, dans le cas où une stabilité de fonctionnement exceptionnelle sera requise.

Des moyens classiques de mise en température du cristal peuvent toutefois être adjoints à l'oscillateur décrit précédemment en vue de jouer un rôle essentiellement au démarrage et d'accélérer notamment la mise à la température d'inversion du cristal, le maintien à cette température d'inversion étant ensuite effectué comme indiqué précédemment de façon prépondérante grâce à la chaleur dégagée dans le cristal par la vibration elle-même. Les moyens classiques de mise en température du cristal destinés à pouvoir fournir une énergie de quelques joules au démarrage du système peuvent comprendre une résistance électrique 76 extérieure à l'enceinte 400 ou, selon les applications, une résistance interne constituée par une couche résistive, non représentée, déposée sur les plateaux 2, 3 de support des électrodes 4, 5. Même dans le cas où ces moyens classiques de mise en température sont utilisés à titre auxiliaire, la dépendance de la fréquence du résonateur par rapport à la température est fortement atténuée dès lors que, pour des fréquences de l'ordre de quelques mégahertzs, la puissance électrique appliquée aux électrodes d'excitation du résonateur est supérieure à environ cinquante microwatts et, pour la vibration utile, n'est pas trop éloignée de la valeur optimum pour laquelle le vieillissement est nul.

Dans tous les cas, les flux de chaleur issus du cristal doivent être limités en régime permanent. Pour ce faire, l'isolement de la ou des enceintes entourant le résonateur doit être particulièrement soigné.

Dans le mode de réalisation des figures 1 et 2, les électrodes déposées sur les plateaux 2, 3 sont reliées aux circuits 75 par des fils de liaison 171 qui sont de préférence chauffés à l'aide de très faibles puissances, de l'ordre de 10 mw, pour les porter à une température de l'ordre de la température d'inversion du cristal et limiter ainsi les fuites de chaleur vers l'extérieur. Le chauffage des fils de liaison 171 peut d'ailleurs être aisément réalisé au moyen des seules déperditions de chaleur dues aux éléments des circuits 75, dans la mesure où ces derniers sont placés au voisinage immédiat de l'enceinte 400.

L'efficacité du système peut être augmentée si, comme dans le cas du mode de réalisation de la figure 2, plusieurs écrans réflecteurs tels que 500, 600 sont disposés en dehors même de la première enceinte 400, et si le vide est réalisé à l'intérieur de ces enceintes 500, 600, les enceintes étant reliées entre elles par des plots isolants 611, 612. Les pinces 411, 412 de support du résonateur 1, 2, 3 dans l'enceinte 400 sont également réalisées en un matériau isolant. Dans le cas du mode de réalisation de la figure 2, où plusieurs écrans électromagnétiques sont disposés en dehors même de l'enceinte 400, l'écran interne tel que 300 présent dans le mode de réalisation de la figure 1 peut être supprimé, mais il reste important que dans ce cas le résonateur soit entouré de l'écran 200 déposé sur les plateaux 2, 3 eux-mêmes.

Diverses modifications et adjonctions peuvent être apportées par l'homme de l'art aux dispositifs qui viennent d'être décrits. Ainsi, selon une variante de réalisation, les électrodes 4, 5 peuvent ne pas être totalement indépendantes des couches 200 formant écran déposées sur les plateaux 2, 3 et/ou le cristal 1 et l'une des électrodes peut dans ce cas être au même potentiel de référence que lesdites parties d'écran 200.

**Revendications**

1. Oscillateur à haute fréquence autothermostaté, du type comprenant, monté dans une enceinte étanche (400), un résonateur piézoélectrique constitué par au moins un cristal piézoélectrique (1) muni d'une partie périphérique continue (12), formant bague reliée à une partie centrale (11), par une zone intermédiaire (13), qui est évidée dans sa majeure partie et comprend au moins deux ponts (131, 132) de liaison pour rendre solidaires l'une de l'autre la partie centrale et la partie périphérique, et deux plateaux (2, 3) diélectriques pour supporter et maintenir des électrodes excitatrices (4, 5), sans contact avec et en regard respectivement de chacune des faces de l'une des parties centrale et périphérique qui constitue alors la partie active (11), vibrante du cristal, l'autre partie du cristal qui constitue une partie de support (12), pour le cristal étant maintenue en position entre lesdits plateaux diélectriques, caractérisé en ce que le contact, thermiquement isolant, entre la partie de support (12), du cristal et les deux plateaux diélectriques (2, 3) est limité à une surface discontinue d'étendue réduite constituée par un nombre fini d'éléments (61, 62, 71, 72, 73, 74) de surface de contact directe, en ce qu'au moins un écran électromagnétique réflecteur de radiations infra-rouges (300) est disposé à l'intérieur même de l'enceinte étanche au voisinage immédiat du résonateur piézoélectrique et en ce que la puissance électrique appliquée aux électrodes excitatrices est d'au moins cinquante microwatts.

2. Oscillateur autothermostaté selon la revendication 1, caractérisé en ce que le nombre fini d'éléments de surface de contact de la partie de support du cristal est égal à quatre.

3. Oscillateur autothermostaté selon la revendication 1 ou la revendication 2, caractérisé en ce que les parties des faces internes des plateaux diélectriques situées en regard du cristal mais non recouvertes d'électrodes et non en contact avec le cristal sont polies et recouvertes d'un écran électromagnétique, réflecteur de radiations infra-rouges (222, 232).

4. Oscillateur autothermostaté selon l'une quelconque des revendications 1 à 3, caractérisé en ce que les faces externes des plateaux diélectriques sont polies et recouvertes d'un écran électromagnétique réflecteur de radiations infra-rouges (221, 223, 231, 233).

5. Oscillateur autothermostaté selon l'une quelconque des revendications 1 à 4, caractérisé en ce que la partie de support (12) du cristal est polie et recouverte d'un écran électromagnétique réflecteur de radiations infra-rouges (211, 212, 213).

6. Oscillateur autothermostaté selon l'une quelconque des revendications 1 à 5, caractérisé en ce que le ou les écrans électromagnétiques, réflecteurs de radiations infra-rouges, sont constitués par un dépôt métallique d'or, d'argent ou de cuivre.

7. Oscillateur autothermostaté selon l'une quelconque des revendications 1 à 6, caractérisé en ce que les écrans électromagnétiques, réflecteurs de radiations infra-rouges, sont constitués par des éléments multicouches réflecteurs correspondant à un quart de longueur d'onde pour les radiations infra-rouges.

8. Oscillateur autothermostaté selon l'une quelconque des revendications 1 à 7, caractérisé en ce qu'il comprend un capteur de température (74), disposé à proximité immédiate de la paroi de l'enceinte étanche entourant le résonateur piézoélectrique et en ce que des moyens sont prévus pour réguler le niveau de la puissance électrique fournie aux électrodes déposées sur les plateaux diélectriques en fonction des signaux délivrés par le capteur.

9. Oscillateur autothermostaté selon l'une quelconque des revendications 1 à 8, caractérisé en ce que les électrodes excitatrices (4, 5) produisant un champ électrique dans la partie active du cristal piézoélectrique reçoivent d'une part une puissance électrique supérieure ou égale à une vingtaine de microwatts pour exciter le cristal selon un mode utile choisi pour déterminer une référence de fréquence et d'autre part une puissance électrique supérieure ou égale à 50 microwatts pour exciter le cristal selon un mode, un partiel ou une vibration anharmonique différents du mode utile choisi pour déterminer une référence de fréquence.

10. Oscillateur selon l'une quelconque des revendications 1 à 9, dans lequel le cristal piézoélectrique est de coupe AT, et est dimensionné et excité pour vibrer à 5 MHz sur le mode partiel 5, caractérisé en ce que la puissance électrique fournie aux électrodes pour exciter la partie active du cristal sur le mode partiel 5 est comprise entre environ 70 et 110 microwatts.

11. Oscillateur selon l'une quelconque des revendications 1 à 9, dans lequel le cristal piézoélectrique est de coupe SC et est dimensionné et excité pour vibrer à 5 MHz sur le mode C et le mode partiel 3, caractérisé en ce que la puissance électrique fournie aux électrodes pour exciter la partie active du cristal sur le mode C et le mode partiel 3 est comprise entre environ 140 et 180 microwatts.

12. Oscillateur selon la revendication 11, caractérisé en ce que le cristal de coupe SC est en outre excité pour vibrer sur le mode B et en ce que la puissance électrique fournie aux électrodes pour exciter la partie active du cristal sur le mode B est de l'ordre d'environ quelques centaines de microwatts.

13. Oscillateur selon l'une quelconque des revendications 9 à 12, caractérisé en ce qu'il comprend deux paires d'électrodes différentes déposées sur les plateaux diélectriques en regard de la partie active du cristal pour exciter ladite partie active sur un mode utile de référence de fréquence et sur un mode additionnel de chauffage.

14. Oscillateur selon l'une quelconque des revendications 9 à 12, caractérisé en ce qu'il comprend une seule paire d'électrodes déposées sur les plateaux diélectriques en regard de la partie active du cristal pour exciter ladite partie active sur un mode utile de référence de fréquence et sur un mode additionnel de chauffage, et en ce que les circuits électroniques (75) de l'oscillateur comprennent des circuits de filtrage pour isoler la composante utile de référence de fréquence du signal électrique appliqué aux électrodes.

15. Oscillateur selon l'une quelconque des revendications 1 à 14, caractérisé en ce qu'il comprend un écran électromagnétique réflecteur de radiations infra-rouges constitué par un matériau isolant thermiquement recouvert d'une couche d'un matériau réflecteur, disposé à l'intérieur de l'enceinte isolante et entourant l'ensemble du résonateur piézoélectrique.

16. Oscillateur selon l'une quelconque des revendications 1 à 15, caractérisé en ce que l'enceinte étanche comprend un capot poli recouvert sur ses deux faces d'une couche d'un matériau réfléchissant.

17. Oscillateur selon l'une quelconque des revendications 1 à 16, caractérisé en ce que les liaisons électriques entre d'une part les électrodes déposées sur les plateaux diélectriques et d'autre part les circuits électroniques de l'oscillateur sont portées par un dispositif de chauffage annexe consommant une puissance de l'ordre d'une dizaine de milliwatts à une température de l'ordre de la température d'inversion du cristal.

18. Oscillateur selon la revendication 17, caractérisé en ce que le dispositif de chauffage annexe utilise les déperditions de chaleur des circuits de l'enceinte étanche de l'oscillateur piézoélectrique.

19. Oscillateur selon l'une quelconque des revendications 1 à 18, caractérisé en ce qu'il comprend une résistance électrique additionnelle de démarrage disposée au voisinage de l'enceinte étanche.

20. Oscillateur selon l'une quelconque des revendications 1 à 19, caractérisé en ce que l'une des électrodes et les écrans électromagnétiques, réflecteurs de radiations infra-rouges déposés sur les plateaux diélectriques et/ou la partie de support du cristal sont à un même potentiel de référence.

21. Oscillateur selon l'une quelconque des revendications 1 à 20, caractérisé en ce qu'il est disposé dans une atmosphère dont la température est très inférieure à la température d'inversion du cristal piézoélectrique.

## Claims

1. High frequency, thermostatically self-controlled, oscillator of a type that comprises a piezoelectric resonator mounted in a sealed container (400) and composed of at least one piezoelectric crystal (1) provided with a continuous peripheral part (12), that forms a ring connected to a central part (11) by an intermediate zone (13), which is recessed over the greater part of its area and comprises at least two connection bridges (131, 132), to connect the central part and the peripheral part solidly together, and two dielectric plates (2, 3), to hold and maintain the exciting electrodes (4, 5), without contact with, and respectively opposite, each of the sides of one of the central and peripheral sections which then constitutes the active vibrating part (11) of the crystal, the other part of the crystal that constitutes a support part (12), for the crystal is maintained in position between the said dielectric plates, characterised by the fact that the contact between the top part of the crystal and the two dielectric plates is limited to a discontinuous surface of reduced extent composed of a finite number of direct contact surfaces elements (61, 62, 71, 72, 73, 74), by the fact that at least one infra-red reflecting screen (300), is disposed inside the sealed container in the immediate vicinity of the piezoelectric resonator, and by the fact that the electric power applied to the exciting electrodes is at least 50 microwatts.

2. Thermostatically self-controlled oscillator, according to claim 1, characterised by the fact that the finite number of contact surface elements of the support part of the crystals is equal to four.

3. Thermostatically self-controlled oscillator according to claim 1 or 2, characterised by the fact that the parts of the internal sides of the dielectric plates located opposite the crystal but not covered by electrodes and not in contact with the crystal, are polished and covered with an infra-red electromagnetic screen.

4. Thermostatic self-controlled oscillator, according to claim 1 to 3, characterised by the fact that the external sides of the dielectric plates are polished and covered with an infra-red electromagnetic screen.

5. Thermostatically self-controlled oscillator, according to one of claims 1 to 4, characterised by the fact that the support part of the crystal is polished and covered with an infra-red electromagnetic screen.

6. Thermostatically self-controlled oscillator, according to any of claims 1 to 5, characterised by the fact that the infra-red electromagnetic screen or screens, consist of a metallic deposit of gold, silver or copper.

7. Thermostatically self-controlled oscillator, according to any of claims 1 to 6, characterised by the fact that the electromagnetic screens are composed of multi-layer reflecting elements corresponding to one quarter wave length for infra-red radiations.

8. Thermostatically self-controlled oscillator in conformity with any of claims 1 to 7, characterised by the fact that it comprises a temperature sensor (74), disposed in immediate proximity to the wall of the sealed container surrounding the piezoelectric resonator, and by the fact that means are provided to regulate the electric power fed to the electrodes deposited on the dielectric plates as a function of signals transmitted by the sensor.

9. Thermostatically self-controlled oscillator, according to any of claims 1 to 8, characterised by the fact that the piezoelectric crystal that recieves, firstly, an electric power greater than or equal to 20 microwatts approximately to excite the crystal in accordance with an effective mode chosen to determine a frequency reference and, secondly, an electric power greater than or equal to 50 microwatts to excite the crystal in accordance with a mode, a partial or an anharmonic vibration different from the effective mode chosen to determine a frequency reference.

10. Oscillator, according to any of claims 1 to 9, in which the piezoelectric crystal is of AT cut and is dimensioned and excited to vibrate at 5 MHz in partial mode 5, characterised by the fact that the electric power fed to the electrodes to excite the active part of the crytal in partial mode 5, lies between approximately 70 microwatts and 110 microwatts.

11. Oscillator, according to any of claims 1 to 9, in which the piezoelectric crystal is of cut SC and is dimensioned and excited to vibrate at 5 MHz in mode C and in partial mode 3, characterised by the fact that electric power fed to the electrodes to excite the active part of the crystal in mode C and in partial mode 3, lies between approximately 140 microwatts and 180 microwatts.

12. oscillator, according to claim 11, characterised by the fact that the crystal of cut SC is, also, excited to vibrate in mode B, and by the fact that the electric power fed to the electrodes to excite the active part of the crystal in mode B is of the order of approximately a few hundredths of microwatts.

13. Oscillator, according to any of claims 9 to 12, characterised by the fact that it comprises two pairs of different electrodes deposited on dielectric plates opposite the active part of the crystal to excite the said active part in an effective frequency reference mode and in an additional heating mode.

14. Oscillator, according to any of claims 9 to 12, characterised by the fact that it comprises one pair of electrodes only deposited on dielectric plates opposite the active part of the crystal to excite the said active part in an effective frequency reference mode and in an additional heating mode, and characterised by the fact that the electrical circuits (75) of the oscillator comprise filtering circuits to isolate the effective frequency reference component from the electric signal applied to the electrode.

15. Oscillator, according to any of claims 1 to 14, characterised by the fact that it comprises an infra-red electromagnetic screen composed of an insulation material thermally covered with a layer of reflecting material, disposed inside the insulating container and surrounding the whole piezoelectric resonator.

16. Oscillator, according to any of claims 1 to 15, characterised by the fact that the sealed container comprises a polished cover, covered on both sides with a layer of reflecting material.

17. Oscillator, according to any of claims 1 to 16, characterised by the fact that the electric connections between, firstly, the electrode deposited on the dielectric plates, and secondly, the electronic circuits of the oscillator, are raised to a temperature of the order of the crystal inversion temperature by an auxiliary heating device that consumes a power of the order of 10 milliwatts.

18. Oscillator, according to claim 17, characterised by the fact that the auxiliary heating device makes use of the heat losses from the electronic circuits of the oscillator placed near to the sealed container of the piezoelectric oscillator.

19. Oscillator, according to any of claims 1 to 18, characterised by the fact that it comprises an additional electric resistor for startup, disposed near to the sealed container.

20. Oscillator, according to any of claims 1 to 19, one of the electrodes and the infra-red electromagnetic screens deposited on the dielectric plates and/or the support section of the crystal are at the same reference voltage.

21. Oscillator, according to any of claims 1 to 20, characterised in that it is disposed in an atmosphere of which the temperature is very much less than the inversion temperature of the piezoelectric crystal.

## Ansprüche

1. Hochfrequenz-Oszillator mit Eigenthermostat, nach einem Modell, das in einem dichten Gehäuse (400) eine piezoelektrische Resonanzanlage enthält, die aus mindestens einem piezoelektrischen Kristall (1) besteht, der einen durchlaufenden Peripherieteil (12) aufweist, der einen Ring darstellt, der mit einem Zentralteil (11) über eine Zwischenzone (13) verbunden ist, die in ihrem grössten Teil ausgehohlt ist und mindestens zwei Verbindungs-Brücken (131, 132) aufweist, die den Zentralteil und den Peripherieteil miteinander verbinden, sowie zwei dielektrische Platten (2, 3), welche die Anregungselektroden (4, 5) tragen und halten, gegenüber, jedoch ohne kontakt mit jeder jeweiligen Flächen des einen der Zentral- bzw. Peripherie-Teile, welche dann den aktiven und vibrierenden Teil (11) des Kristalls darstellt, während der andere Teil des Kristalls, der einen Teil des Trägers (12) für den Kristall darstellt, in einer gegebenen Stellung zwischen den besagten dielektrischen Platten gehalten wird, dadurch gekennzeichnet, dass dieser thermisch isolierende Kontakt zwischen dem Trägerteil (12), dem Kristall und den beiden dielektrischen Platten (2, 3) auf eine nicht kontinuierliche Oberfläche begrenzten Ausmasses eingeschränkt ist, die aus einer gegebenen Anzahl Bauteile (61, 62, 71, 72, 73, 74) der direkten Kontaktoberfläche besteht, und dadurch gekennzeichnet, dass mindestens ein elektromagnetischer Schirm zur Reflektion von Infrarot-Strahlungen (300) im Inneren selbst des dichten Gehäuses oder in der unmittelbaren Umgebung der piezoelektrischen Resonanzanlage untergebracht ist und dadurch gekennzeichnet, dass die an die Anregungselektroden angelegte elektrische Leistung mindestens fünfzig Mikrowatt beträgt.

2. Oszillator mit Eigenthermostat nach Anspruch 1, dadurch gekennzeichnet, dass die gegebene Anzahl Bauteile der Kontaktoberfläche des Trägerteils des Kristalls mindestens vier beträgt.

3. Oszillator mit Eigenthermostat nach Anspruch 1 oder Anspruch 2, dadurch gekennzeichnet, dass die Innenseiten der dielektrischen Platten, die sich gegenüber dem Kristall befinden aber nicht mit Elektroden bestückt sind und auch mit dem Kristall nicht in Berührung kommen, poliert und mit einem ekektromagnetischen Schrim überzogen sind, der Infrarot-Strahlungen reflektiert (222, 232).

4. Oszillator mit Eigenthermostat nach einem der Ansprüche 1 bis 3, dadurch gekennzeichnet, dass die Aussenflächen der dielektrischen Platten poliert und mit einem elektromagnetischen Schirm überzogen sind, der Infrarot-Strahlungen reflektiert (221, 223, 231, 233).

5. Oszillator mit Eigenthermostat nach einem der Ansprüche 1 bis 4, dadurch gekennzeichnet, dass der Trägerteil (12) des Kristalls poliert und mit einem elektromagnetischen Schirm überzogen ist, der Infrarotstrahlungen reflektiert (211, 212, 213).

6. Oszillator mit Eigenthermostat nach einem der Ansprüche 1 bis 5, dadurch gekennzeichnet, dass der oder die elektromagnetische (n) Schirme zur Reflektion von Infrarot-Strahlungen aus einer Metallbeschichtung bestehen, wobei das hierzu verwendete Metall Gold, Silber oder Kupfer sein kann.

7. Oszillator mit Eigenthermostat nach einem der Ansprüche 1 bis 6, dadurch gekennzeichnet, dass die elektromagnetischen Schirme zur Reflektion von Infrarot-Strahlungen aus reflektierenden Mehrschichten-Bauteilen bestehen, die einem Viertel der Wellenlänge der betreffenden Infrarot-Strahlungen entsprechen.

8. Oszillator mit Eigenthermostat nach einem der Ansprüche 1 bis 7, dadurch gekennzeichnet, dass er mit einer Temperaturmess-Sonde (74) bestückt ist, die sich in unmittelbarer Nähe der Wand des dichten Gehäuses befindet, welche die piezoelektrische Resonanzanlage umgibt und dadurch gekennzeichnet, dass Vorrichtungen vorgesehen sind, um die Stärke der elektrischen Leistung zu regulieren, die an die Elektroden angelegt wird, die sich auf den dielektrischen Platten befinden, und dies jeweils in Abhängigkeit von den voin der Mess-Sonde gelieferten Signalen.

9. Oszillator mit Eigenthermostat nach einem der Ansprüche 1 bis 8, dadurch gekennzeichnet, dass die Anregungselektroden (4, 5), die im aktiven Teil des piezoelektrischen Kristalls ein elektrisches Feld erzeugen, einerseits mit einer elektrischen Leistung von mindestens rund zwanzig Mikrowatt gespeist werden, um den Kristall auf eine Art und Weise auzuregen, die so gewählt wird, dass eine Referenzfrequenz erzeugt wird, und andererseits mit einer elektrischen Leistung von mindestens 50 Microwatt, um den Kristall auf eine Art und Weise, eine Teil- oder dysharmonische Schwingung anzuregen, die von derjenigen Art und Weise unerschiedlich ist, die zur Erzeugung der Referenzfrequenz gewählt worden war.

10. Oszillator mit Eigenthermostat nach einem der Ansprüche 1 bis 9, dadurch gekennzeichnet, dass der piezoelektrische Kristall einen Schnitt AT aufweist und in seinen Abmessungen so ausgelegt ist und so angeregt wird, dass er im Teilmodus 5 bei 5 MHz schwingt, dadurch gekennzeichnet, dass die an die Elektroden angelegte elektrische Leistung, die dazu dient, den aktiven Teil des Kristalls im Teilmodus 5 anzuregen, zwischen rund 70 und 110 Mikrowatt liegt.

11. Oszillator mit Eigenthermostat nach einem der Ansprüche 1 bis 9, in welchem der piezoelektrische Kristall einen Schnitt SC aufweist und in seinen Abmessungen so ausgelegt ist und so angeregt wird, dass er im Modus C und im Teilmodus 3 bei 5 MHz schwingt, dadurch gekennzeichnet, dass die an die Elektroden angelegte elektrische Leistung, die dazu dient, den aktiven Teil des Kristalls im Modus C und im Teilmodus 3 anzuregen, zwischen rund 140 und 180 Mikrowatt liegt.

12. Oszillator mit Eigenthermostat nach Anspruch 11, dadurch gekennzeichnet, dass der Kristall mit Schnitt SC ausserdem so angeregt wird, dass er im Modus B schwingt, und dadurch gekennzeichnet, dass die an die Elektroden angelegte elektrische Leistung, die dazu dient, den aktiven Teil des Kristalls im Modus B anzuregen, in der Grössenordnung von rund einigen Hundert Mikrowatt liegt.

13. Oszillator mit Eigenthermostat nach einem der Ansprüche 9 bis 12, dadurch gekennzeichnet, dass er zwei Paare verschiedener Elektroden aufweist, die auf den dielektrischen Platten gegenüber dem aktiven Teil des Kristalls untergebracht sind, um diesen aktiven Teil auf eine Art und Weise anzuregen, die für die Referenzfrequenz verwendbar ist, sowie auf eine zusätzliche Art und Weise, die als Heizmodus dient.

14. Oszillator mit Eigenthermostat nach einem der Ansprüche 9 bis 12, dadurch gekennzeichnet, dass nur eines der Elektrodenpaare, die auf den dielektrischen Platten gegenüber dem aktiven Teil des kristalls untergebracht sind, um diesen aktiven Teil auf eine Art und Weise anzuregen, die für die Referenzfrequenz verwendbar ist, sowie auf eine zusätzliche Art und Weise, die als Heizmodus dient, und dadurch gekennzeichnet, dass die elektronischen Schaltkreise (75) des Oszillators Filterkreise aufweisen, die dazu dienen, diejenige Komponente des an die Elektroden angelegten elektrischen Signals zu isolieren, die als Referenz-Frequenz verwendet wird.

15. Oszillator mit Eigenthermostat nach einem der Ansprüche 1 bis 14, dadurch gekennzeichnet, dass er einen elektromagnetischen Schirm zur Reflektion von Infrarot-Strahlungen aufweist, der aus einem thermisch isolierenden Werkstoff besteht und mit einer Schicht eines reflektierenden Werkstoffs beschichtet ist, und sich im Inneren des Isoliergehäuses befindet und die gesamte Baugruppe der piezoelektrischen Resonanzanlage umhüllt.

16. Oszillator mit Eigenthermostat nach einem der Ansprüche 1 bis 15, dadurch gekennzeichnet, dass das dichte Gehäuse eine polierte Haube aufweist, die auf beiden Seiten mit einer Schicht reflektierenden Materials beschichtet ist.

17. Oszillator mit Eigenthermostat nach einem der Ansprüche 1 bis 16, dadurch gekennzeichnet, dass die elektrischen Verbindungen zwischen den auf den dielektrischen Platten untergebrachten Elektroden einerseits und den elektronischen Schaltkreisen des Oszillators andererseits von einer zusätzlichen Heizanlage getragen werden, an die eine Leistung in der Grössenordnung von rund 10 Milliwatt angeschlossen ist, und die eine Temperatur liefert, die in der Grössenordnung der Umkehrtemperatur des Kristalls liegt.

18. Oszillator mit Eigenthermostat nach Anspruch 17, dadurch gekennzeichnet, dass die zusätzliche Heizanlage die Wärmeverluste aus den Schaltkreisen des dichten Gehäuses des piezoelektrischen Oszillators verwendet.

19. Oszillator mit Eigenthermostat nach einem der Ansprüche 1 bis 18, dadurch gekennzeichnet, dass er einen zusätzlichen elektrischen Widerstand aufweist, der zum Anfahren verwendet wird und sich in der Nähe des dichten Gehäuses befindet.

20. Oszillator mit Eigenthermostat nach einem der Ansprüche 1 bis 19, dadurch gekennzeichnet, dass eine der Elektroden und die elektromagnetischen Schirme zur Reflektion der Infrarot-Strahlungen, die sich auf den dielektrischen Platten und/oder dem Trägerteil des Kristalls befinden, an ein und dasselbe Referenz-Potential angeschlossen sind.

21. Oszillator mit Eigenthermostat nach einem der Ansprüche 1 bis 20, dadurch gekennzeichnet, dass er in einer Atmosphäre untergebracht ist, deren Temperatur erheblich unter der Umkehrtemperatur des piezoelektrischen Kristalls liegt.

Fig. 1

Fig. 2

Fig_3

Fig_4

Fig. 5

Fig. 6